# EUROPÄISCHE PATENTSCHRIFT

(11) **EP 0 328 905 B1**
(45) Veröffentlichungstag und Bekanntmachung des Hinweises auf die Patenterteilung: **29.06.1994**
(21) Anmeldenummer: 89101204.9
(22) Anmeldetag: 24.01.1989
(51) Int. Cl.: H03K 17/08, H01L 27/08

(54) **Schaltungsanordnung zum Schutze einer integrierten Schaltung**
Circuit arrangement for the protection of an integrated circuit
Montage pour la protection d'un circuit intégré

(30) Priorität: 15.02.1988 DE 3804726
(43) Veröffentlichungstag der Anmeldung: 23.08.1989
(73) Patentinhaber: SIEMENS AKTIENGESELLSCHAFT, 80333 München (DE)
(72) Erfinder: Lenz, Michael, D-8011 Zorneding (DE); Schwertlein, Frank-Lothar, Dipl.-Ing. (FH), D-8000 München 19 (DE); Horchler, Wolfgang, Dipl.-Ing., D-8013 Haar (DE)

(56) Entgegenhaltungen:
- DE-A- 3 343 201
- DE-A- 3 639 731
- US-A- 3 885 998
- US-A- 3 890 634
- US-A- 3 969 748
- US-A- 4 078 208
- US-A- 4 540 894
- MACHINE DESIGN, Band 56, Nr. 28, 6. Dezember 1984, Seiten 107-110, Cleveland, Ohio, US; B.H. CARLISLE: "The Gremlins lurking in power ICs"

## Beschreibung

Die Erfindung betrifft eine Schaltungsanordnung zum Schutze einer integrierten Schaltung.

Treten am Ausgang einer integrierten Schaltung Spannungen auf, die außerhalb des Versorgungsspannungsbereiches der integrierten Schaltung liegen, wie etwa beim Betrieb mit induktiven Lasten, so werden intern parasitäre Schaltungsstrukturen aktiviert. Es werden beispielsweise pn-Übergänge zwischen einem p-dotierten Substrat und mehreren n-dotierten Wannen gebildet, die beim Betrieb in Flußrichtung parasitäre Dioden- und Transistorstrukturen ergeben. Dabei wird jeder n-dotierten Wanne Strom entzogen, was in bestimmten Fällen zu Funktionsstörungen einzelner Schaltungsstrukturen und zur Beschädigung der integrierten Schaltung führt.

Es ist bekannt, Ausgänge von integrierten Schaltungen mittels Freilaufdioden gegenüber unzulässigen Spannungen zu schützen. Dazu werden in der Regel Dioden in Sperrichtung von beiden Versorgungsspannungen ausgehend auf den Ausgang der integrierten Schaltung geführt. Um auftretende Substratströme zu begrenzen, ist es notwendig, einen Widerstand zwischen Ausgang und Last zu schalten oder die Freilaufdioden als Schottky-Dioden auszuführen. Darüber hinaus besteht die Möglichkeit, einen Ausgang mittels zweier gegeneinander geschalteter Zenerdioden mit geeigneten Durchbruchsspannungen abzusichern. In den genannten Fällen ist jedoch insbesondere die Notwendigkeit eines zusätzlichen, externen Schaltungsaufwandes von Nachteil. Eine Integration der Freilaufdioden ist aufgrund der damit verbundenen Bildung weiterer parasitärer Schaltungsstrukturen von geringem Nutzen.

Wie beispielsweise aus Thomas M. Frederiksen, "Schwierigkeiten und ihre Behebung beim Anwenden integrierter Operationsverstärker", Elektroniker Nr. 6, 1985, S. 43 ff bekannt ist, lassen sich diese parasitären Bauelemente beim Auslegen der Schaltung eines Operationsverstärkers ausnützen. In diesem Fall werden die parasitären Bauelemente absichtlich eingeschaltet und die Schaltkreise sind dementsprechend ausgelegt. Ein falscher Betrieb kann dagegen parasitäre Bauelemente einschalten, deren Vorhandensein unerwartet ist: in diesem Fall können sich interessante Vorgänge abspielen, die zu einer Beschädigung der Schaltung führen.

In der DE 36 39 731 ist eine Schutzeinrichtung für Leistungs-PNP-Transistoren beschrieben in welcher die Kollektor-Emitter Strecke eines parasitären Transistors parallel zu der von der Basis des Leistungs-PNP-Transistors zum Ausgangsknoten der Schaltung gebildeten Strecke liegt. Diese Schutzeinrichtung dient jedoch dazu den annormalen Treibereffekt von parasitären Transistoren, die unter bestimmten Grenzbedingungen in monolithisch integrierten Schaltungen des Bipolartyps angeregt werden, zu verhindern.

Weiters ist aus US-A-3 890 634 bekannt, in einer integrierten Schaltung durch geeignete Dotierung bzw. Kontaktierung einen lateralen Transistor so zu integrieren daß dieser nur beim Auftreten eines bestimmten Spannungszustandes aktiv wird und infolgedessen die Sättigung eines Schalttransistors verhindert, wobei die Kollektor-Emitter Strecke des lateralen Transistors parallel zur Basis-Emitter Strecke des Schalttransistors geschaltet ist.

Der Erfindung liegt demgemäß die Aufgabe zugrunde, beim Schutz einer integrierten Schaltung vor den Folgen einer am Ausgang anliegenden, den Versorgungsbereich der integrierten Schaltung überschreitenden Spannung insbesondere den externen Schaltungsaufwand zu reduzieren und den die Funktion der integrierten Schaltung beeinträchtigenden Einfluß nicht vermeidbarer parasitärer Schaltungsstrukturen zu verringern.

Die Aufgabe wird bei einer gattungsgemäßen Schaltungsanordnung durch die Merkmale des Anspruchs 1 gelöst.

Weiterbildungen der Erfindung sind Gegenstand von Unteransprüchen.

Die Erfindung bringt den Vorteil mit sich, daß die Notwendigkeit externer Schutzmaßnahmen und eines damit verbundenen externen Schaltungsaufwandes entfällt. Der funktionsschädliche Einfluß nicht vermeidbarer, parasitärer Schaltungsstrukturen wird minimal gehalten, da diese zusammen mit zusätzliche eingebrachten Schaltungsstrukturen als weitere Elemente in die Schutzmaßnahmen mit einbezogen werden.

Die Erfindung wird nachfolgend anhand von den in den FIG 1-3 dargestellten Ausführungsbeispielen näher erläutert. Es zeigen:
- FIG 1: ein Schaltbild einer ersten Ausführungsform einer obengenannten Schaltungsanordnung,
- FIG 2: ein Schaltbild einer zweiten Ausführungsform einer obengenannten Schaltungsanordnung,
- FIG 3: ein Schaltbild einer dritten Ausführungsform einer obengenannten Schaltungsanordnung.

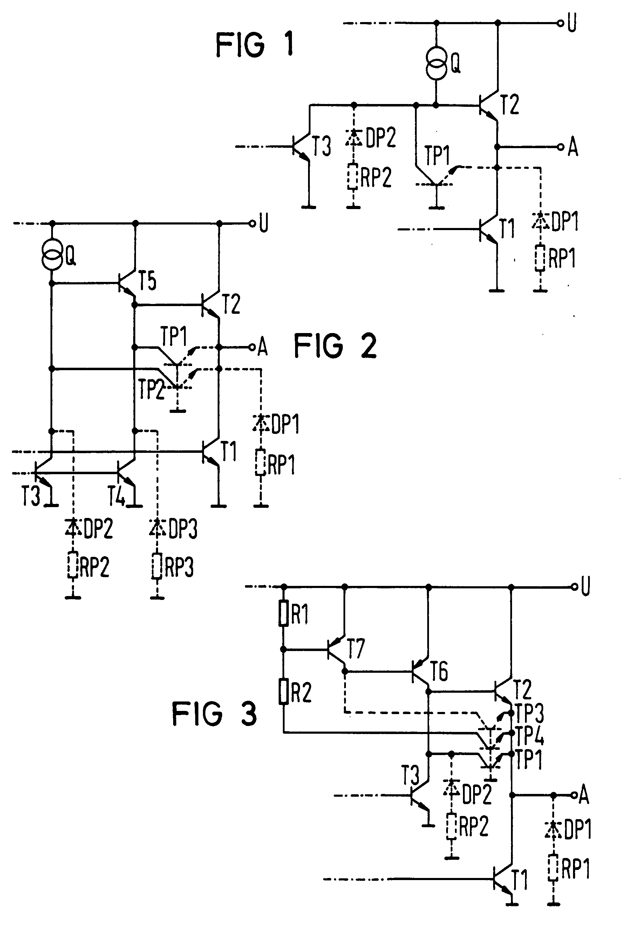

In FIG 1 der Zeichnung ist eine bei integrierten Schaltungen gebräuchliche Form einer Ausgangsstufe durch ein Prinzipschaltbild dargestellt. Die Ausgangsstufe wird im wesentlichen durch eine aus zwei npn-Transistorstrukturen T1 und T2 bestehende quasikomplementäre Gegentaktendstufe gebildet, wobei eine Transistorstruktur T2 über ihren Kollektor mit einem positiven Betriebspotential U verbunden ist und eine Transistorstruktur T1 mit ihrem Emitter auf negativem Betriebspotential, das in diesem Fall durch Masse gegeben ist, liegt. Die Basis der Transistorstruktur T2 wird zum einen durch eine auf positives Betriebspotential bezogene Stromquelle Q gespeist und zum andern durch eine in Emitterschaltung betriebene npn-Transistorstruktur T3 auf Masse geführt. Die Basis der Transistorstruktur T1 und die Basis der Transistorstruktur T3 sind jeweils mit weiteren Schaltungsteilen verbunden, die im vorliegenden Falle jedoch nicht von Interesse sind. Neben diesen gewollten, eben erläuterten Schaltungsstrukturen, treten darüber hinaus auch parasitäre, zunächst nicht beabsichtigte, Strukturen auf. Zur besseren Unterscheidung sind in der Zeichnung die gewollten Strukturen durchgezeichnet und die parasitären Strukturen gebrochen ausgeführt. Die mit dem Emitter auf Masse liegenden Transistorstrukturen T1 und T3 weisen im wesentlichen jeweils eine zwischen Substrat und Kollektor auftretende parasitäre Schaltungsstruktur auf, welche aus der Serienschaltung eines ohmschen Widerstandes RP1,RP2 und einer in Sperrichtung liegenden Diode DP1,DP2 besteht. Aus der zwischen einem, durch die Verbindung der Transistorstrukturen T1 und T2 gegebenen, Ausgang A und Masse liegenden parasitären Struktur mit der Diode DP1 und dem Widerstand RP1 wird durch Einbringen einer zusätzlichen n-dotierten Wanne eine parasitäre Transistorstruktur TP1 geschaffen, deren Basis auf Masse und deren Emitter auf dem Potential des Ausgangs A liegt. Der Kollektor der parasitären Transistorstruktur TP1 ist mit der Basis der Transistorstruktur T2 verbunden.

Das in FIG 2 der Zeichnung gezeigte Ausführungsbeispiel geht aus dem in FIG 1 gezeigten hervor und wurde demgegenüber um eine in Darlingtonschaltung ausgeführte Ansteuerstufe für die Endstufe erweitert. Dazu ist die Basisleitung der Transistorstruktur T2 aufgetrennt und eine Transistorstruktur T5 so eingefügt, daß ihr Emitter mit der Basis und ihr Kollektor mit dem Kollektor der Transistorstruktur T2 verbunden ist. Die Basis der Transistorstruktur T5 ist wie vormals die Basis der Transistorstruktur T2 mit der Transistorstruktur T3 und der Stromquelle Q verschaltet. Des weiteren ist der Emitter der Transistorstruktur T5 mit dem Kollektor einer Transistorstruktur T4 zusammengeführt, deren Basis-Emitter-Strecke parallel zu der von Transistorstruktur T3 liegt. Als zusätzliche parasitäre Schaltungsstruktur ergibt sich eine Widerstands-Diodenstruktur RP3,DP3 zwischen Masse und dem Kollektor der Transistorstruktur T4, sowie eine durch Einbringen einer zusätzlichen n-dotierten Wanne aus der Diodenstruktur DP1 hervorgegangenen Transistorstruktur TP2, deren Kollektor an dem Kollektor der Transistorstruktur T3 anliegt.

Das in FIG 1 dargestellte Ausführungsbeispiel wird in FIG 3 der Zeichnung dahingehend abgeändert, daß die Stromquelle Q durch eine pnp-Transistorstruktur T6 zu ersetzen ist, die mit ihrem Emitter auf positivem Betriebspotential U liegt und deren Kollektor mit der Basis der Transistorstruktur T3 zusammengeführt ist. Über die Kollektor-Emitter-Strecke einer weiteren pnp-Transistorstruktur T7 wird die Basis der Transistorstruktur T6 auf positives Betriebspotential gelegt. Die Basis der Transistorstruktur T7 ist mit dem Abgriff eines Spannungsteilers R1, R2 verbunden, der über einen Widerstand R1 mit dem positiven Betriebspotential U und über einen Widerstand R2 mit dem Kollektor einer parasitären Transistorstruktur TP4 verbunden ist.

Diese wiederum geht durch Einbringen einer zusätzlichen, n-dotierten Wanne aus der Diodenstruktur DP1 hervor, die darüber hinaus auch mit einer, als Basis der Transistorstruktur T6 fungierenden, n-dotierten Wanne in Wechselwirkung steht und damit eine parasitäre Transistorstruktur TP3 bildet.

Nachdem der prinzipielle Aufbau der in der Zeichnung dargestellten Schaltungsanordnung erläutert worden ist, wird nunmehr auf die Arbeitsweise dieser Schaltungsanordnung näher eingegangen.

Beispielsweise durch Abschalten einer induktiven Last tritt am Ausgang A ein in Bezug auf Masse negatives Potential auf. Dadurch werden die aus der Transistorstruktur T1 hervorgehende, parasitäre Dioden-Widerstands-Struktur DP1,RP1 und die aus der Transistorstruktur T3 hervorgehende Dioden-Widerstands-Struktur DP2,RP2 aktiviert. Damit liegt jedoch die Transistorstruktur T2 mit der Basis über die parasitäre Dioden-Widerstands-Struktur DP2,RP2 auf Masse und mit dem Emitter auf einem gegenüber Masse negativen Potential, was zum Durchsteuern der Transistorstruktur T2 führt. Ein Überschreiten der zulässigen Basis-Emitterspannung oder des zulässigen Emitter-Kollektor-Stromes ist für die Transistorstruktur T2 dabei nicht auszuschließen. Durch Einbringen einer oder mehrerer n-dotierter Wannen entstehen in Verbindung mit der parasitären Diodenstruktur DP1 parasitäre Transistorstrukturen TP1,TP2,TP4, welche, da sie ohnehin bereits teilweise vorhanden sind und erst bei einer Fehlfunktion aktiviert werden, vorteilhafterweise in Weiterbildung der Erfindung als steuernde Elemente zum Schutze gefährdeter Schaltungsteile eingesetzt werden. Von besonderem Vorteil sind dabei laterale parasitäre Transistorstrukturen, da sie gegenüber anderen Strukturen höhere Durchbruchspannungen, kleinere Kapazitäten und einen geringeren Platzbedarf aufweisen. Eine einfache und daher vorteilhafte Anwendung parasitärer Transistorstrukturen besteht darin, die Basis-Emitter-Strecke einer gegebenen Transistorstruktur T2 gemäß des kennzeichnenden Teils des Anspruchs 4 kurzzuschließen. Da die Basis der parasitären Transistorstruktur TP1 auf Masse und der Emitter auf Ausgangspotential liegt, wird bei einem negativen Potential am Ausgang der Transistor durchgesteuert und sperrt damit die Transistorstruktur T2.

In gleicher Weise wird der in FIG 2 gezeigte Darlington-Transistor, bestehend aus den Transistorstrukturen T5 und T2, durch die parasitäre Transistorstruktur TP2 zwischen Basis und Emitter kurzgeschlossen.

Handelt es sich um einen komplementären Darlington-Transistor, der wie in FIG 3 dargestellt aus den Transistorstrukturen T2 und T6 besteht, so ist es von Vorteil, in Ausbildung der Erfindung eine parasitäre Transistorstruktur TP4 zur Ansteuerung einer Hilfsschaltung zu verwenden. Bei einem am Ausgang A anliegenden negativen Potential öffnet die parasitäre Transistorstruktur TP3, wodurch dem Basisgebiet der Transistorstruktur T6 Strom entzogen wird. Um ein Durchsteuern der Transistorstruktur T6 zu verhindern, wird zwischen deren Basis und deren Emitter eine zusätzliche Transistorstruktur T7 gesetzt, die bei Durchsteuerung durch die parasitäre Transistorstruktur TP4 die Basis-Emitter-Strecke der Transistorstruktur T6 kurzschließt. Der Widerstand R1 dient dabei zur Erhöhung der Störfestigkeit und der Widerstand R2 zur Strombegrenzung.

Abschließend sei noch darauf hingewiesen, daß eine Integration zusätzlicher Diodenstrukturen gemäß der kennzeichnenden Teile der Ansprüche 4 bis 6 in eine gegebene Schaltungsstruktur im Sinne einer gesteigerten Schutzwirkung insbesondere bei hohen Freilaufströmen von Vorteil ist. Die dabei entstehenden parasitären Schaltungsstrukturen werden zweckmäßigerweise als weitere steuernde Elemente in Verbindung mit einer Schutzschaltung verwendet.

## Patentansprüche

1. Schaltungsanordnung zum Schutze einer Leistungsendstufe in einer integrierten Schaltung vor Beschädigung durch eine an einem Ausgang (A) der Leistungsendstufe anliegende, den Versorgungsspannungsbereich der integrierten Schaltung überschreitende Spannung, unter Einbeziehung parasitärer Schaltungsstrukturen, wobei die Leistungsendstufe wenigstens einen ersten und einen zweiten Leistungstransistor (T1, T2) aufweist, deren Laststrecken in Reihe geschaltet sind, wobei die Laststrecke des ersten Transistors (T1) an Masse und die des zweiten Transistors (T2) an die Versorgungsspannung (V) geschaltet ist und daß wenigstens ein dritter Transistor (T3) vorgesehen ist, dessen Kollektor mit der Basis des zweiten Transistors (T2) und dessen Emitter mit Masse verbunden ist, mit einer gegebenen Anzahl von parasitären Schaltungsstrukturen, welche Kollektor-Emitterstrecken aufweisen, die eine Reihenschaltung aus einer Diode (DP1, DP2, DP3) und einem Widerstand (RP1, RP2, RP3) bilden, welche parallel zur Kollektor-Emitterstrecke des jeweils mit Masse verbundenen Transistors (T1, T3, T4) geschaltet ist, sowie wenigstens eine Basis-Emitterstrecke aufweist, wobei die Basis mit Masse und der Emitter mit dem Knotenpunkt (A) der Reihenschaltung der Laststrecken des ersten und zweiten Leistungstransistors verbunden ist, und wobei wenigstens eine zusätzliche Kollektorstruktur eingebracht wird, die zusammen mit der Basis-Emitterstrecke einen Schutztransistor (TP1, TP2) bildet und die mit der Basis des mit der Versorgungsspannung verbundenen Transistors (T2, T5, T6) verbunden ist, so daß der Schutztransistor (TP1, TP2) und die parasitären Schaltungsstrukturen eine Schutzschaltung bilden, die durch die Spannung am Ausgang aktiviert, schützend wirksam werden.

2. Schaltungsanordnung nach Anspruch 1,
**dadurch gekennzeichnet,** daß zwischen der Basis des zweiten Transistors (T2) und dem Kollektor des dritten Transistors (T3) wenigstens eine komplementäre Transistorstufe (T4, T5) geschaltet ist.

3. Schaltungsanordnung nach Anspruch 1,
**dadurch gekennzeichnet,** daß eine Darlingtonkomplementärstufe aus dem zweiten Leistungstransistor (T2) mit einem weiteren Transistor (T6) gebildet wird, und daß eine zusätzliche Transistorstufe (T7) vorgesehen ist, deren Emitter mit der Versorgungsspannung und deren Kollektor mit der Basis des mit der Versorgungsspannung verbundenen Darlingtontransistors verbunden ist,
daß eine weitere Basis-Emitterstrecke parallel zur parasitären Schutztransistorstruktur (TP1) geschaltet ist, und daß eine zusätzliche Kollektorstruktur eingebracht wird, die zusammen mit der Basis-Emitterstrecke einen Schutztransistor (TP4) bildet, und daß diese Kollektorstruktur an die Basis der zusätzlichen Transistorstruktur (T7) gekoppelt ist.

4. Schaltungsanordnung nach mindestens einem der Ansprüche 1 bis 3,
**dadurch gekennzeichnet,** daß zusätzlich eine Diodenstruktur mitintegriert wird, die in Sperrichtung zwischen einem Ausgang (A) und dem positiven Versorgungspotential (U) liegt.

5. Schaltungsanordnung nach mindestens einem der Ansprüche 1 bis 4,
**dadurch gekennzeichnet,** daß zusätzlich eine Diodenstruktur mitintegriert wird, die in Sperrichtung zwischen negativem Betriebspotential und einem Ausgang (A) liegt.

6. Schaltungsanordnung nach mindestens einem der Ansprüche 1 bis 5,
**dadurch gekennzeichnet,** daß zusätzlich eine Diodenstruktur mitintegriert wird, die in Sperrichtung zwischen einem Ausgang (A) und Masse liegt.

## Claims

1. Circuit arrangement for protecting a power output stage in an integrated circuit against damage by a voltage present at an output (A) of the power output stage and exceeding the supply voltage range of the integrated circuit, including parasitic circuit structures, the power output stage exhibiting at least one first and one second power transistor (T1, T2), the load sections of which are connected in series, the load section of the first transistor (T1) being connected to earth and that of the second transistor (T2) being connected to the supply voltage (V) and in that at least one third transistor (T3) is provided, the collector of which is connected to the base of the second transistor (T2) and the emitter of which is connected to earth, having a given number of parasitic circuit structures which exhibit collector-emitter sections which form a series circuit of a diode (DP1, DP2, DP3) and a resistor (RP1, RP2, RP3), which circuit is connected in parallel with the collector-emitter section of the transistor (T1, T3, T4) in each case connected to earth, and exhibits at least one base-emitter section, the base being connected to earth and the otter being connected to the node (A) of the series circuit of the load sections of the first and second power transistor, and at least one additional collector structure being introduced which, together with the base-emitter section, forms a protective transistor (TP1, TP2) and which is connected to the base of the transistor (T2, T5, T6) connected to the supply voltage so that the protective transistor (TP1, TP2) and the parasitic circuit structures form a protective circuit which, activated by the voltage at the output, become protectively effective.

2. Circuit arrangement according to Claim 1, characterized in that at least one complementary transistor stage (T4, T5) is connected between the base of the second transistor (T2) and the collector of the third transistor (T3).

3. Circuit arrangement according to Claim 1, characterized in that a complementary Darlington stage is formed from the second power transistor (T2) with a further transistor (T6), and in that an additional transistor stage (T7) is provided, the emitter of which is connected to the supply voltage and the collector of which is connected to the base of the Darlington transistor connected to the supply voltage, in that a further base-emitter section is connected in parallel with the protective parasitic transistor structure (TP1), and in that an additional collector structure is introduced which, together with the base-emitter section, forms a protective transistor (TP4), and in that this collector structure is coupled to the base of the additional transistor structure (T7).

4. Circuit arrangement according to at least one of Claims 1 to 3, characterized in that, additionally, a diode structure is also integrated which is located in the reverse direction between an output (A) and the positive supply potential (U).

5. Circuit arrangement according to at least one of Claims 1 to 4, characterized in that, additionally, a diode structure is also integrated which is located in the reverse direction between the negative operating potential and an output (A).

6. Circuit arrangement according to at least one of Claims 1 to 5, characterized in that, additionally, a diode structure is also integrated which is located in the reverse direction between an output (A) and earth.

## Revendications

1. Montage pour protéger un étage final de puissance dans un circuit intégré vis-à-vis d'un endommagement dû à une tension appliquée à une sortie (A) de l'étage final de puissance et qui dépasse la gamme des tensions d'alimentation du circuit intégré, et incluant des structures de circuits parasites, et dans lequel l'étage final de puissance possède au moins des premier et second transistors de puissance (T1, T2), dont les sections de charge sont branchées en série, la section de charge du premier transistor (T1) est connectée à la masse et la section de charge du second transistor (T2) est placée à la tension d'alimentation (V), et dans lequel il est prévu au moins un troisième transistor (T3), dont le collecteur est connecté à la base du second transistor (T2) et dont l'émetteur est connecté à la masse, et comportant un nombre déterminé de structures de circuits parasites, qui possèdent des sections collecteur-émetteur, qui forment un circuit série constitué par une diode (DP1, DP2, DP3) et une résistance (RP1, RP2, RP3), qui est branchée en parallèle avec la voie collecteur-émetteur du transistor (T1, T3, T4) raccordé respectivement à la masse, et possède au moins une voie base base-émetteur, la base étant raccordée à la masse et l'émetteur étant raccordé au point de jonction (A) du circuit série des sections de charge des premier et second transistors de puissance, et dans lequel il est prévu au moins une structure supplémentaire de collecteur, qui forme, conjointement avec la voie base-émetteur, un transistor de protection (TP1, TP2) et qui est raccordée à la base du transistor (T2, T5, R6) placé à la tension d'alimentation, de sorte que le transistor de protection (TP1, TP2) et les structures de circuits parasites forment un circuit de protection, qui, en étant activé par la tension présente à la sortie, fournit une action de protection.

2. Montage suivant la revendication 1, caractérisé par le fait qu'au moins un étage à transistors complémentaires (T4, T5) est branché entre la base du second transistor (T2) et le collecteur du troisième transistor (T3).

3. Montage suivant la revendication 1, caractérisé par le fait qu'un étage complémentaire de Darlington est formé par le second transistor de puissance (T2) et un autre transistor (T6), et qu'il est prévu un étage supplémentaire à transistor (T7), dont l'émetteur est placé à la tension d'alimentation et dont le collecteur est raccordé à la base du transistor de Darlington placé à la tension d'alimentation,
qu'une autre voie base-émetteur est branchée en parallèle avec la structure parasite à transistor de protection (TP), et
il est prévu une structure de collecteur supplémentaire qui forme, conjointement avec la voie base-émetteur, un transistor de protection (TP4), et que cette structure de collecteur est couplée à la base de la structure à transistor supplémentaire (T7).

4. Montage suivant au moins l'une des revendications 1 à 3, caractérisé par le fait qu'en supplément est intégrée simultanément une structure de diode, qui est bloquante entre une sortie (A) et le potentiel de tension positive (U).

5. Montage suivant au moins l'une des revendications 1 à 4, caractérisé par le fait qu'en supplément est intégrée conjointement une structure de diode, qui est bloquante entre le potentiel de service négatif et une sortie (A).

6. Montage suivant au moins l'une des revendications 1 à 5, caractérisé par le fait qu'en supplément est intégrée conjointement une structure de diode qui est bloquante entre une sortie (A) et la masse.
